**Europäisches Patentamt**

(19) **European Patent Office**

**Office européen des brevets**

(11) Veröffentlichungsnummer: **0 015 364**
**B1**

(12) # EUROPÄISCHE PATENTSCHRIFT

(45) Veröffentlichungstag der Patentschrift:
**18.05.83**

(21) Anmeldenummer: **80100193.4**

(22) Anmeldetag: **16.01.80**

(51) Int. Cl.³: **H 03 K 3/355**, H 03 K 3/354

(54) Multivibrator aus Feldeffekt-Transistoren.

(30) Priorität: **28.02.79 US 16261**

(43) Veröffentlichungstag der Anmeldung:
**17.09.80 Patentblatt 80/19**

(45) Bekanntmachung des Hinweises auf die Patenterteilung:
**18.05.83 Patentblatt 83/20**

(84) Benannte Vertragsstaaten:
**DE FR GB**

(56) Entgegenhaltungen:
**DE-A-2 502 689**
**GB-A-1 288 391**
**US-A-3 562 559**
**US-A-3 578 989**
**US-A-3 719 835**

(73) Patentinhaber: *International Business Machines*
**Corporation, Armonk, N.Y. 10504 (US)**

(72) Erfinder: **Blaser, Eugene Martin, Saddleridge Road,**
**Hopewell Junction N.Y. 12533 (US)**

(74) Vertreter: **Gaugel, Heinz, Dipl.-Ing., Schönaicher**
**Strasse 220, D-7030 Böblingen (DE)**

ACTORUM AG

Multivibrator aus Feldeffekt-Transistoren

Die Erfindung bezieht sich auf einen Multivibrator aus Feldeffekt-Transistoren, der Impulse mit definierter Impulsbreite und kurzen Anstiegs- und Abfallzeiten liefert.

Multivibratorschaltungen sind in grosser Vielfalt bekannt. Sie dienen der Erzeugung gesteuerter Signalverläufe und lassen sich in monostabile, bistabile und astabile Multivibratoren unterteilen. Im Zusammenhang mit der vorliegenden Erfindung sind monostabile und astabile Multivibratoren von besonderem Interesse. Diese beiden Arten von Multivibratoren werden häufig zur Erzeugung und Lieferung von Taktimpulsen für andere Schaltungen innerhalb einer Gesamtschaltung verwendet. Der grundsätzliche Unterschied zwischen einem monostabilen und einem astabilen Multivibrator besteht darin, dass der astabile Multivibrator freischwingend ist und eine Impulskette liefert, während ein monostabiler Multivibrator aufgrund eines Auslöseimpulses einen einzelnen Ausgangsimpuls erzeugt.

Die meisten der gegenwärtig bekannten Multivibratoren sind mit bipolaren Transistoren aufgebaut. Mit Feldeffekt-Transistoren aufgebaute Multivibratoren sind in relativ geringer Anzahl entwickelt worden. Der Grund dafür ist in der Eigenschaft der Feldeffekt-Transistoren zu suchen, dass der für das Einschaltverhalten wesentliche Schwellwert nicht genau voraus bestimmbar und auch im Betrieb unkontrollierten Veränderungen unterworfen ist. Diese schlechten Schwellwertcharakteristiken führen zu nicht vorausbestimmbaren und unkontrollierbaren Impulsbreiten und relativ grossen Anstiegs- und Abfallzeiten der Impulse.

Da für viele Schaltanordnungen mit Feldeffekt-Transistoren Multivibratoren zur Erzeugung von bestimmten Impulsen oder von Taktsignalen benötigt werden, ist es derzeit üblich, entsprechende Multivibratoren nicht mit den genannten Schaltungen auf einem Halbleiterchip zu integrieren, sondern die benötigten Impulse ausserhalb des Halbleiterchips zu erzeugen. Will man mitintegrierte Multivibratoren aus Feldeffekt-Transistoren einsetzen, so muss man die geschilderten Nachteile hinsichtlich der gelieferten Impulse in Kauf nehmen. Ein Beispiel für einen Multivibrator aus Feldeffekt-Transistoren, der die geschilderten Nachteile aufweist, ist beispielsweise der US-Patentschrift 3 719 835 zu entnehmen.

Aus der deutschen Offenlegungsschrift 2 502 689 ist ein Multivibrator aus Feldeffekt-Transistoren bekannt, bei dem die angesprochenen Nachteile zum Teil vermieden werden.

Dabei sind zwei (ein ersten und ein zweiter), über eine Kreuzkopplung jeweils zwischen Drain des einen und Gate des anderen verbundene Feldeffekt-Transistoren vorgesehen, die über ihre Source miteinander verbunden sind und deren Drain jeweils über ein Lastelement an ein Betriebspotential angeschlossen ist. Der Kreuzkopplungspfad zwischen der Drain des ersten und dem Gate des zweiten Feldeffekt-Transistors enthält die Reihenschaltung einer Kapazität und eines zweistufigen Verstärkers. Vermieden werden sollen hier im wesentlichen Auswirkungen der baulich- bzw. herstellungsmässig bedingten Streuungen der Schwellenspannungen der Transistoren auf die Betriebsparameter. Betriebsbedingte Schwankungen der Schwellenspannungen werden kaum beeinflusst.

Der Erfindung, wie sie in den Ansprüchen gekennzeichnet ist, liegt die Aufgabe zugrunde, einen Multivibrator aus Feldeffekt-Transistoren anzugeben, bei dem die nachteiligen Auswirkungen der baulich- und betriebsbedingten ungünstigen Schwellwertcharakteristiken der verwendeten Feldeffekt-Transistoren auf die Impulsbreite und die Flankensteilheit der gelieferten Impulse auf relativ einfache Weise vermieden werden.

Die Erfindung wird im folgenden anhand von zwei Ausführungsbeispielen näher erläutert.

Es zeigt:

Fig. 1 das Schaltbild eines erfindungsgemässen monostabilen Multivibrators,

Fig. 2 eine Reihe von Kurven, aus denen sich die Wirkungsweise des Multivibrators nach Fig. 1 ergibt, und

Fig. 3 das Schaltbild eines erfindungsgemässen astabilen Multivibrators.

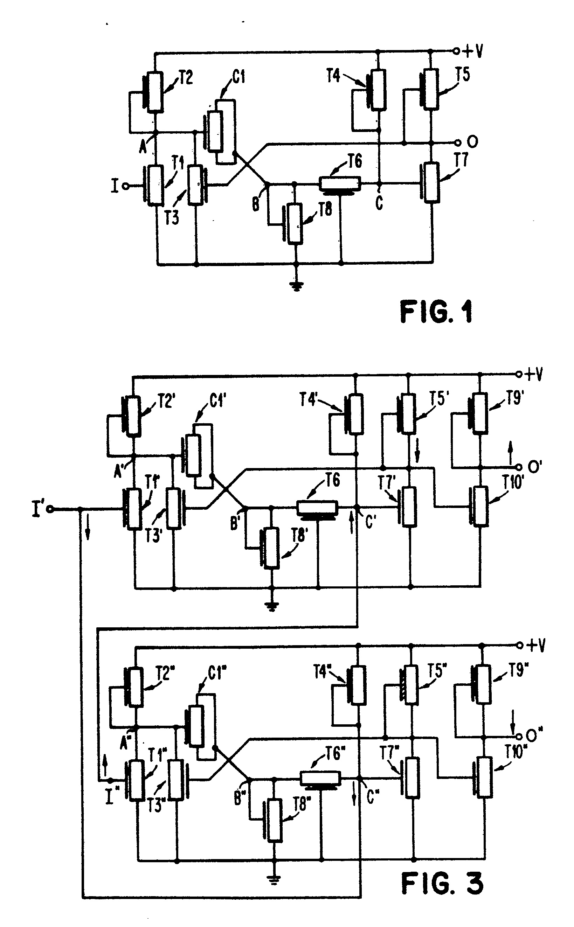

Der in Fig. 1 dargestellte monostabile Multivibrator enthält Feldeffekt-Transistoren des Anreicherungstyps und des Verarmungstyps. Die Feldeffekt-Transistoren des Verarmungstyps unterscheiden sich in der Darstellung dadurch von den Feldeffekt-Transistoren des Anreicherungstyps, dass das Gate mit einer Schraffur versehen ist. Es sei an dieser Stelle darauf hingewiesen, dass in einigen Fällen Feldeffekt-Transistoren der beiden genannten Typen austauschbar sind, wenn im Hinblick auf die Wirkungsweise gewisse Auswirkungen in Kauf genommen werden können. Auch ist zu bemerken, dass die Multivibratoren, die in dem gezeigten Beispiel mit N-Kanal-Feldeffekt-Transistoren aufgebaut sind, auch mit P-Kanal-Feldeffekt-Transistoren verwirklicht werden können.

Der monostabile Multivibrator ist folgendermassen aufgebaut. Ein Transistor T1 ist mit der Drain an einen Knoten A und mit der Source an ein erstes festes Potential (Masse) angeschlossen, während das Gate mit dem Eingang der Schaltung verbunden ist. Ein Transistor T2 dient als Lastwiderstand. Gate und Source dieses Transistors sind miteinander verbunden und an den Knoten A geführt. Die Drain dieses Transistors ist mit dem Anschluss für das positive Betriebspotential +V verbunden.

Das Kernstück des Multivibrators besteht aus zwei kreuzgekoppelten Transistoren T3 und T7. Die Drain-Sourcestrecke des ersten Transistors T3 ist zwischen dem Knoten A und dem Bezugspotential angeordnet. Das Gate dieses Transistors ist direkt mit der Drain des zweiten Transistors T7 und damit mit dem Ausgang verbunden. Der zwi-

schen dem Knoten A und dem Knoten C bzw. dem Gate des zweiten Transistors T7 liegende Kreuzkopplungspfad besteht aus der Serienschaltung einer Kapazität C1 und eines Transistors T6. Das Gate des Transistors T6 ist mit dem Bezugspotential verbunden.

Die Verbindung zwischen der Kapazität C1 und dem Transistor T6 bildet den Knoten B, der gleichzeitig mit dem Gate und der Drain eines Transistors T8 verbunden ist. Die Source des Transistors T8 liegt am Bezugspotential. Bei diesem Transistor T8 handelt es sich um ein sehr kleines Bauelement, das einen hohen Widerstand zwischen Knoten B und Bezugspotential bildet. Ein Transistor T4 ist mit seiner Drain an das Betriebspotential +V und mit Gate und Source an den Knoten C angeschlossen. Ein Transistor T5 ist mit seiner Drain an das Betriebspotential +V und mit Gate und Source an den Ausgang gelegt. Zusammengefasst kann man feststellen, dass die Feldeffekt-Transistoren T3 und T7 mit ihrer Source verbunden und an das Bezugspotential gelegt sind. Beide Transistoren sind jeweils zwischen Gate des einen und Drain des anderen kreuzgekoppelt. Der Kreuzkopplungspfad zwischen der Drain des Transistors T3 und dem Gate des Transistors T7 enthält eine Kapazität C1 und eine Pegelverschiebungsstufe, die sich aus den dem Verarmungstyp angehörenden Feldeffekt-Transistoren T6 und T4 zusammensetzt. In einem Übergangszustand, d. h. also im Zeitpunkt des Schaltvorganges werden der Knoten B und die Kapazität C1 langsam über die Transistoren 4 und 6 aufgeladen. Gleichzeitig beginnt die langsame Aufladung des Knotens C. Sobald sich jedoch die Spannung am Knoten B dem Schwellwert des Transistors 6 nähert, wird dieser Transistor gesperrt. Dies hat zur Folge, dass der gesamte, über den Transistor T4 zugeführte Strom zur Aufladung des Knotens C verwendet wird und dass damit der Transistor T7 in den leitenden Zustand gebracht wird und den Ausgang auf das Bezugspotential (Masse) absenkt.

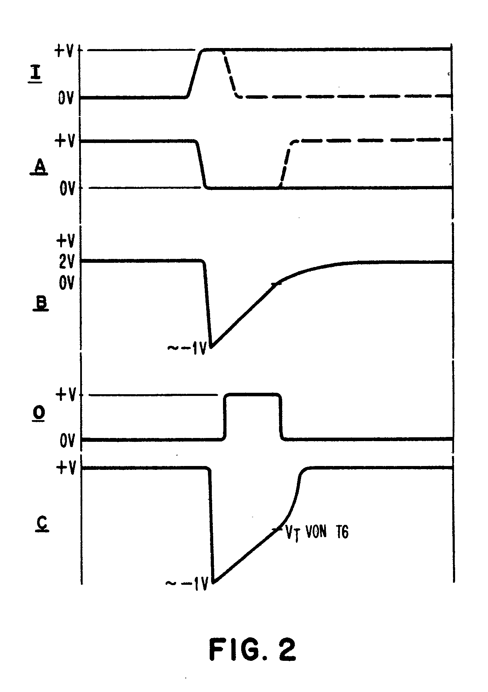

Eine genauere Erklärung der Wirkungsweise des erfindungsgemässen Multivibrators ergibt sich anhand der Fig. 2. Die Kurve I gibt den Signalverlauf am Eingang I des Multivibrators wieder. Da das Eingangssignal zunächst auf dem unteren Pegel liegt, ist der Transistor T1 gesperrt und der Knoten A ist über den Widerstand T2 auf den oberen Pegel aufgeladen. Der obere Pegel (+V) sei beispielsweise auf 5 V festgesetzt, um im Zuge der Beschreibung die verschiedenen in der Schaltung vorkommenden Pegel angeben zu können.

Im weiteren Ablauf wird der Knoten C über die Drain-Sourcestrecke des Transistors T4 auf den oberen Pegel aufgeladen. Damit wird der Transistor T7 leitend und am Ausgang liegt ein unterer Pegel an, der den Transistor T3 gesperrt hält, was mit dem Zustand verträglich ist, dass sich der Knoten A auf dem oberen Pegel befindet. Es ist ein serieller Strompfad vom Betriebspotential +V nach Bezugspotential (Masse) vorhanden und der Strompfad umfasst die Transistoren T4, T6 und T8. Ein wesentliches Merkmal der Erfindung ist in diesem Strompfad zu sehen, in welchem der Transistor T6 dem Verarmungstyp angehört und mit seinem Gate an das Bezugspotential gelegt ist. Feldeffekt-Transistoren des Verarmungstyps weisen typisch eine negative Schwellenspannung in der Gegend von −1,5 bis −2,0 V auf. Während also der Knoten C auf das Betriebspotential +V aufgeladen wird, folgt das Potential im Knoten B anfänglich dem des Knotens C bis es etwa +2,0 V erreicht (dabei ist angenommen, dass der Transistor T6 eine Schwellenspannung $V_T$ von −2 V aufweist). Beim Transistor T8 handelt es sich um ein Bauelement mit hohem Widerstand, so dass der Knoten B auf 2,0 V gehalten wird, solange ihm über die Transistoren T4 und T6 Strom zugeführt wird. Der bisher hierher beschriebene Teil des Funktionsablaufes umfasst die anfänglichen Zustände der Signalverläufe nach Fig. 2.

Es sei nun angenommen, dass dem Eingang I ein Auslöseimpuls zugeführt wird, der ausgehend vom Bezugspotential (Masse) bis zum Betriebspotential +V ansteigt. Mit geringer Verzögerung wird der Transistor T1 leitend und entlädt den Knoten A wie es in Fig. 2 beim entsprechenden Signalverlauf A angedeutet wird. Im Idealfall würde dabei das Potential im Knoten B über die Kapazität C1 um das Betriebspotential (5 V) abfallen. Praktisch jedoch findet ein Abfall des Potentials im Knoten B auf etwa −1 V statt. Durch diesen Abfall wird der Transistor T6 leitend, so dass auch das Potential im Knoten C um einen entsprechenden Wert abgesenkt wird. Fällt also das Potential im Knoten C ebenfalls auf etwa −1 V ab, so wird der Transistor T7 schnell gesperrt und der Ausgang O wird über den Transistor T5 auf das Betriebspotential aufgeladen. Auch dieser Vorgang ist in Fig. 2 aus der entsprechend dem Ausgang O bezeichneten Kurve zu ersehen. Es ist darauf hinzuweisen, dass die in Fig. 2 dargestellten Signalverläufe insbesondere in vertikaler Richtung nicht massstabsgerecht, sondern stark überhöht dargestellt sind, um die Funktionsweise leicht erkennbar zu machen.

Es sei nunmehr wiederum das Eingangssignal I in Fig. 2 betrachtet, und zwar zunächst in der Situation, in der es auf dem oberen Pegel bleibt, wie es durch die durchgezogene Linie angedeutet ist. In diesem Fall bleibt das Potential im Knoten A auf dem unteren Pegel, da der Transistor T1 leitend bleibt. Damit beginnt Strom über den Transistor T4 zu fliessen, wodurch der Knoten C auf den oberen Pegel aufgeladen wird. Da der Transistor T6 leitend ist, folgt das Potential im Knoten B dem des Knotens C und lädt die Kapazität C1 auf. Sobald das Potential im Knoten B 2 V erreicht (Wert der für den Transistor T6 angenommenen Schwellenspannung $V_T$), wird der Transistor T6 gesperrt. Der Transistor T4 leitet jedoch weiter und liefert dem Knoten C einen gleich grossen Strom, der zuvor zum Laden der Kapazität C1 erforderlich war. Eine Folge davon ist, dass die Spannung im Knoten C sehr rasch ansteigt und den Transistor T7 in den leitenden Zustand bringt. Das Potential am Ausgang O fällt auf den unteren Pegelwert ab.

Es sei darauf hingewiesen, dass die Spannung im Knoten B expotentiell ansteigt, solange der Transistor T6 leitend ist. Die Kapazität C1 wird mit einer Zeitkonstanten aufgeladen, die durch die Kapazität C1 selbst und die Transistoren T2 und T4 als Widerstandselemente bestimmt ist. Sobald der Transistor T6 gesperrt wird (in der Nähe des absoluten Wertes der Schwellenspannung des Transistors T6, die mit etwa 2 V angenommen wurde), wird dem Knoten B nur ganz wenig Strom zugeführt, so dass er den Pegel von 2 V nur über den Leckstrom durch den Transistor T6 erreichen kann. Es zeigt sich, dass die Spannung im Knoten C dann plötzlich steil ansteigt, wenn der Transistor T6 in den gesperrten Zustand überzugehen beginnt. Da die Schwellenspannung des Transistors T7 des Anreicherungstyps etwa bei +1 V liegt, wird dieser Transistor schnell leitend, und zwar etwa zu dem Zeitpunkt, in dem der Transistor T6 gesperrt wird.

Der Zeitpunkt, zu dem der Transistor T7 leitend wird, ist nicht nur im voraus bestimmbar, sondern auch einstellbar. Es hat sich gezeicht, dass die Impulsbreite des Ausgangsimpulses direkt proportional der Grösse der Kapazität C1 ist. Das Einschalten des Transistors T7, durch das das Ende des Ausgangsimpulses und damit die Impulsbreite bestimmt wird, kann durch Einstellung der Kapazität C1 oder der Widerstandselemente bestehend aus den Transistoren T2 und T4 kontrolliert werden. Eine Veränderung der Kapazität C1 von 0,5 auf 1,5 pF ergibt eine Impulsbreitenänderung am Ausgang O des Multivibrators linear von 20 auf 60 Nanosekunden.

Ein weiteres Merkmal des erfindungsgemässen Multivibrators besteht darin, dass der Ausgangstaktimpulse aufgrund unterschiedliche Impulsbreite aufweisender Eingangssignale liefert. Ausserdem ist nur ein einzelnes Eingangssignal am Eingang I, d.h. am Gate des Transistors T1 erforderlich. Es sei beispielsweise auf den Signalverlauf am Eingang I hingewiesen, wie er in Fig. 2 durch die gestrichelte Linie angedeutet ist. Nimmt man den Fall an, dass das Eingangssignal wieder auf das Bezugspotential abfällt, sobald das Ausgangssignal den oberen Pegel erreicht hat. Zu diesem Zeitpunkt bringt das Ausgangssignal den Transistor T3 in den leitenden Zustand und hält den Knoten A auf dem unteren Pegel, und zwar obwohl am Eingang I bereits wieder der untere Pegel anliegt. Sobald jedoch der Ausgangsimpuls beendet ist, wird der Transistor T3 gesperrt und das Potential im Knoten A steigt auf das Betriebspotential +V an, wie es im entsprechenden Kurvenverlauf in Fig. 2 angegeben ist.

Die angegebenen Vorteile ergeben sich nicht nur bei dem beschriebenen monostabilen Multivibrator, sondern auch bei einem astabilen Multivibrator. Ein solcher astabiler Multivibrator ist in Fig. 3 dargestellt. Es ist leicht zu erkennen, dass die astabile Funktionsweise mit Hilfe zweier Schaltungen nach Fig. 1 erreichbar ist. Aus diesem Grunde sind entsprechende Bauelemente und Knoten mit entsprechenden Bezugszeichen versehen und in der einen Teilschaltung mit einem einfachen und in der anderen Teilschaltung mit einem doppelten Strichindex versehen. Beim astabilen Multivibrator nach Fig. 3 ist lediglich an die beiden Ausgänge eine Treiberschaltung T9' und T10' bzw. T9'' und T10'' angeschlossen. Falls nur der eine Ausgang benötigt wird, genügt die Anschaltung eines einzelnen Treibers. Die Drain des Transistors T9' ist wie die anderen Transistoren an das Betriebspotential +V angeschlossen, der Transistor kann jedoch auch an ein unterschiedliches Betriebspotential angelegt werden, um so einen unterschiedlichen oberen Ausgangspegel zu erzielen. An den beiden Ausgängen der Schaltung erscheint ein gegenphasiges Ausgangssignal.

Die astabile Betriebsweise erreicht man dadurch, dass das Signal am Knoten C' an den Eingang der anderen Stufe, d.h., an das Gate des Transistors T1'' geführt wird. Entsprechend ist der Knoten C'' mit den Eingang der anderen Stufe, d.h., mit dem Gate des Transistors T1' verbunden. In beiden Fällen könnte anstelle des Knotens C' bzw. C'' auch der jeweilige Ausgang mit dem zugeordneten Eingang verbunden werden. Bei diesem astabilen Multivibrator können unter Umständen die Transistoren T3' und T3'' weggelassen werden, da hier nicht mehr verhindert werden muss, dass der Knoten A' bzw. A'' auf einen anfänglich unteren Pegel abgesenkt wird.

Die Kapazitäten C1, C1' und C1'' bestehen aus einer Feldeffekt-Transistorstruktur, wobei das Gate die eine Belegung und Drain und Source zusammen die andere Belegung der Kapazität bilden. Selbstverständlich lassen sich auch anders aufgebaute Kapazitäten einsetzen.

### Patentansprüche

1. Multivibrator aus Feldeffekt-Transistoren, der Impulse mit definierter Impulsbreite und steilen Impulsflanken liefert, wobei zwei (ein erster und ein zweiter), über eine Kreuzkopplung jeweils zwischen Drain des einen und Gate des anderen verbundene Feldeffekt-Transistoren (T3, T7) vorgesehen sind, die über ihre Source miteinander verbunden sind und deren Drain jeweils über ein Lastelement (T2, T5) an ein Betriebspotential (+V) angeschlossen ist, und bei dem der Kreuzkopplungspfad zwischen der Drain des ersten (T3) und dem Gate des zweiten Feldeffekt-Transistors (T7) die Reihenschaltung einer Kapazität (C1) und einer Pegelverschiebungsstufe (T4, T6, T8) enthält, dadurch gekennzeichnet, dass die Pegelverschiebungsstufe einen dritten Feldeffekt-Transistor (T6) enthält, dessen Drain-Sourcestrecke zwischen dem einen Anschluss der mit ihrem anderen Anschluss an der Drain des ersten Feldeffekt-Transistors (T3) liegenden Kapazität (C1) und dem Gate des zweiten Feldeffekt-Transistor (T7) angeordnet ist und dessen Gate mit einem Bezugspotential (Masse) verbunden ist, dass ein vierter Feldeffekt-Transistor (T4) vom Verarmungstyp mit Gate und Source am Verbindungspunkt zwischen der Source-Drainstrecke des dritten (T6) und dem Gate des zweiten Feldeffekt-Transistors (T7) angeschlossen ist, wobei die Drain mit dem Betriebspotential (+V) verbunden ist, so dass der dritte und vierte Feldeffekt-Transistor (T6, T4) einen Aufladestromkreis vom Betriebspotential (+V) zur Kapazität (C1) bilden, solange der dritte Feldeffekt-Transistor (T6) leitend ist, und dass ein fünfter Feldeffekt-Transistor (T8) mit Gate und Drain am Verbindungspunkt zwischen der Source-Drainstrecke des dritten Feldeffekt-Transistors (T6) und der Kapazität (C1) angeschlossen ist, wobei die Source mit der Source des ersten und zweiten Feldeffekt-Transistors (T3, T7) verbunden ist.

2. Multivibrator nach Anspruch 1, dadurch gekennzeichnet, dass der erste (T3) und der zweite Feldeffekt-Transistor (T7) vom Anreicherungstyp und der dritte Feldeffekt-Transistor (T6) vom Verarmungstyp ist und dass das Gate des dritten (T6) und jeweils die Source des ersten (T3) und zweiten Feldeffekt-Transistors (T7) an das Bezugspotential (Masse) angeschlossen ist.

3. Multivibrator nach den Ansprüchen 1 oder 2, dadurch gekennzeichnet, dass als Lastelement des ersten und zweiten Feldeffekt-Transistors (T3, T7) jeweils ein Feldeffekt-Transistor (T2, T5) des Verarmungstyps dient, wobei jeweils Source und Gate dieses Feldeffekt-Transistors mit der Drain des zugeordneten ersten bzw. zweiten Feldeffekt-Transistors (T3, T7) und die Drain mit dem Betriebspotential (+V) verbunden ist.

4. Multivibrator nach den Ansprüchen 1 bis 3, dadurch gekennzeichnet, dass parallel zur Source-Drainstrecke des ersten Feldeffekt-Transistors (T3) die Source-Drainstrecke eines weiteren Feldeffekt-Transistors (T1) angeordnet ist, dessen Gate den Eingang (I) für ein Auslösesignal bildet.

5. Multivibrator nach den Ansprüchen 1 bis 4, dadurch gekennzeichnet, dass an die Drain des zweiten Feldeffekt-Transistors (T7) ein Ausgangstreiber (T9, T10) angeschaltet ist.

6. Multivibrator nach einem oder mehreren der Ansprüche 1 bis 5 als einer ersten Teilschaltung, dadurch gekennzeichnet, dass eine zweite entsprechende Teilschaltung vorgesehen ist und dass das Gate des zweiten Feldeffekt-Transistors (T7') der ersten Teilschaltung mit dem Eingang (I'') der zweiten Teilschaltung und dass das Gate des zweiten Feldeffekt-Transistors (T7'') der zweiten Teilschaltung mit dem Eingang (I') der ersten Teilschaltung verbunden ist.

## Claims

1. Field effect transistor multivibrator supplying pulses with a defined pulse width and steep pulse edges, two (a first and a second) field effect transistor (T3, T7) respectively connected via a cross-coupling between drain of the one and gate of the other being provided, said transistors being interconnected via their source, and having their drain respectively connected via a load element (T2, T5) to a reference potential (+V), and the cross-coupling path between the drain of the first (T3) and the gate of the second field effect transistor (T7) comprising the series arrangement of a capacitor (C1) and a level shifting stage (T4, T6, T8), characterized in that the level shifting stage comprises a third field effect transistor (T6) whose drain-source path is arranged between the one connection of the capacitor (C1) applied with its other connection to the drain to the first field effect transistor (T3), and the gate of the second field effect transistor (T7), and whose gate is connected to a reference potential (ground), that a fourth field effect transistor (T4) of the depletion type is connected with gate and source at the point of connection between the source-drain path of the third (T6) and the gate of the second field effect transistor (T7), the drain being connected to the reference potential (+V), so that the third and fourth field effect transistor (T6, T4) form a charge current circuit from the reference potential (+V) to the capacitor (C1) as long as the third field effect transistor (T6) is conductive, and that a fifth field effect transistor (T8) with gate and drain is connected at the point of connection between the source-drain path of the third field effect transistor (T6) and the capacitor (C1), the source being connected to the source of the first and second field effect transistors (T3, T7).

2. Multivibrator as claimed in claim 1, characterized in that the first (T3) and the second field effect transistor (T7) are of the enhancement type, and the third field effect transistor (T6) is of the depletion type, and that the gate of the third (T6) and respectively the source of the first (T3) and of the second field effect transistor (T7) are connected to the reference potential (ground).

3. Multivibrator as claimed in any one of claims 1 or 2, characterized in that as a load element of the first and second field effect transistor (T3, T7) one respective field effect transistor (T2, T5) of the depletion type is used, source and gate of this field effect transistor being respectively connected to the drain of the associated first or second field effect transistor (T3, T7), and a drain to the reference potential (+V).

4. Multivibrator as claimed in any one of claims 1 to 3, characterized in that in parallel to the source-drain path of the first field effect transistor (T3) the source-drain path of another field effect transistor (T1) is provided whose gate forms the input (I) for a release signal.

5. Multivibrator as claimed in any one of claims 1 to 4, characterized in that an output driver (T9, T10) is connected to the drain of the second field effect transistor (T7).

6. Multivibrator as claimed in any one or several of claims 1 to 5 as a first part circuit, characterized in that a second corresponding part circuit is provided, and that the gate of the second field effect transistor (T7') of the first part circuit is connected to the input (I'') of the second part circuit, and that the gate of the second field effect transistor (T7'') of the second part circuit is connected to the input (I') of the first part circuit.

**Revendications**

1. Multivibrateur à transistors à effet de champ délivrant des impulsions avec une largeur d'impulsion définie et des flancs d'impulsion à pente importante, dans lequel deux transistors à effet de champ (T3, T7) (un premier et un deuxième) respectivement connectés par l'intermédiaire d'un couplage croisé entre le drain de l'un et la porte de l'autre, sont prévus, lesdits transistors étant interconnectés par leur source, et ayant leur drain respectivement connecté par l'intermédiaire d'un élément de charge (T2, T5) à un potentiel de référence (+V), et le chemin de couplage croisé entre le drain du premier (T3) et la porte du second transistor à effet de champ (T7) comprenant l'agencement en série d'une capacité (C1) et un étage de décalage de niveau (T4, T6, T8), caractérisé en ce que l'étage de décalage de niveau comprend un troisième transistor à effet de champ (T6) dont le chemin drain–source est disposé entre une borne de la capacité (C1) (dont l'autre borne est appliquée au drain du premier transistor à effet de champ (T3) et la porte du deuxième transistor à effet de champ (T7), et dont la porte est connectée à un potentiel de référence (masse); en ce qu'un quatrième transistor à effet de champ (T4) du type à appauvrissement est connecté avec porte et source au point de connexion entre le chemin source–drain du troisième (T6) et la porte du deuxième transistor à effet de champ (T7), le drain étant connecté au potentiel de référence (+V), de façon que les troisième et quatrième transistors à effet de champ (T6, T4) forment un circuit de courant de charge de la capacité (C1) au potentiel de référence (+V) aussi longtemps que le troisième transistor à effet de champ (T6) est conducteur; et en ce qu'un cinquième transistor à effet de champ (T8) est connecté au point de connexion entre le chemin source–drain du troisième transistor à effet de champ (T6) et la capacité (C1), la source étant connectée à la source des premier et deuxième transistors à effet de champ (T3, T7).

2. Multivibrateur selon la revendication 1, caractérisé en ce que le premier (T3) et le deuxième transistors à effet de champ (T7) sont du type à enrichissement, et le troisième transistor à effet de champ (T6) est du type à appauvrissement, et en ce que la porte du troisième (T6) et, respectivement, la source du premier (T3) et du second transistor à effet de champ (T7), sont connectées au potentiel de référence (masse).

3. Multivibrateur selon l'une quelconque des revendications 1 ou 2, caractérisé en ce qu'en tant qu'élément de charge des premier et deuxième transistors à effet de champ (T3, T7), on utilise un transistor à effet de champ (T2, T5), respectivement, du type à appauvrissement, la source et la porte de ce transistor à effet de champ étant respectivement connectées au drain des premier et deuxième transistors à effet de champ (T3, T7) associés, et un drain au potentiel de référence (+V).

4. Multivibrateur selon l'une quelconque des revendications 1 à 3, caractérisé en ce que, en parallèle avec le chemin source–drain du premier transistor à effet de champ (T3), le chemin source–drain d'un autre transistor à effet de champ (T1) est prévu dont la porte forme l'entrée (I) pour un signal de déconditionnement.

5. Multivibrateur selon l'une quelconque des revendications 1 à 4, caractérisé en ce qu'un excitateur de sortie (T9, T10) est connecté au drain du deuxième transistor à effet de champ (T7).

6. Multivibrateur selon l'une ou plusieurs des revendications 1 à 5 en tant que premier circuit partiel, caractérisé en ce qu'un deuxième circuit partiel correspondant est prévu et en ce que la porte du deuxième transistor à effet de champ (T7') du premier circuit partiel est connectée à l'entrée (I'') du deuxième circuit partiel et en ce que la porte du deuxième transistor à effet de champ (T7'') du deuxième circuit partiel est connectée à l'entrée (I') du premier circuit partiel.

**FIG. 1**

**FIG. 3**

FIG. 2